# EUROPEAN PATENT APPLICATION

(11) **EP 4 723 569 A1**
(43) Date of publication of application: **08.04.2026**
(21) Application number: 23941984.9
(22) Date of filing: 21.06.2023
(51) Int. Cl.: H04L 27/36

(54) **COMMUNICATION METHOD AND RELATED APPARATUS**

(71) Applicant: Huawei Technologies Co., Ltd., Shenzhen, Guangdong 518129 (CN)
(72) Inventor: WANG, Xianbin, Shenzhen, Guangdong 518129 (CN); ZHANG, Huazi, Shenzhen, Guangdong 518129 (CN); TONG, Jiajie, Shenzhen, Guangdong 518129 (CN); WANG, Jun, Shenzhen, Guangdong 518129 (CN)
(74) Representative: Körber, Martin Hans
(86) International application number: PCT/CN2023/101983
(87) International publication number: WO 2024/259713

(57) **Abstract**

This application provides a communication method and a related apparatus, to reduce complexity of geometric shaping. The method includes: A first device obtains a to-be-transmitted bit sequence; and modulates the bit sequence based on a third modulation scheme, to map the bit sequence to each constellation point in a third constellation point set, to obtain a modulated symbol. The first device sends the modulated symbol to a second device. Correspondingly, the second device receives the modulated symbol; and demodulates the modulated symbol, to obtain the bit sequence. A plurality of constellation points in the third constellation point set are non-uniformly distributed, the third constellation point set is similar to a first constellation point set corresponding to a first modulation scheme, the first constellation point set is a subset of a second constellation point set, the second constellation point set is a set of a plurality of constellation points corresponding to a predefined second modulation scheme, an order of the second modulation scheme is higher than an order of the first modulation scheme, and an order of the third modulation scheme is the same as the order of the first modulation scheme.

## Description

### TECHNICAL FIELD

This application relates to the field of communication technologies, and in particular, to a communication method and a related apparatus.

### BACKGROUND

A high-order modulation technology is a general technology in a mobile communication system. A plurality of bits are mapped to a same symbol through high-order modulation and then sent through a channel, so that a spectral efficiency can be further improved. Information-theoretic analysis shows that for a system with limited average power, a channel capacity can be further improved by optimizing distribution of constellation points, that is, by using a shaping technology. It is intuitively understood that, in high-order modulation, because different symbols have different energy, more low-energy symbols and fewer high-energy symbols may be sent, to reduce average transmit power of signals and improve a performance gain.

Currently, the foregoing objective may be achieved in a geometric shaping manner or a probabilistic shaping manner. Although probabilistic shaping achieves a larger performance gain, probabilistic shaping requires a larger modification to a coding and modulation procedure. In contrast, geometric shaping requires a smaller modification to a coding procedure. Therefore, a specific performance gain can be achieved at low implementation complexity costs.

However, geometric shaping is related to problems such as irregular constellation points and optimized constellation construction, and consequently has a high description complexity.

### SUMMARY

This application provides a communication method and a related apparatus, to reduce complexity of geometric shaping.

According to a first aspect, this application provides a communication method. The method may be applied to a first device. For example, the method may be performed by the first device, or may be performed by a component (for example, a chip or a chip system) configured in the first device, or may be implemented by a logical module or software that can implement all or some functions of the first device. This is not limited in this application.

For example, the method includes: obtaining a to-be-transmitted bit sequence; and modulating the bit sequence based on a third modulation scheme, to map the bit sequence to each constellation point in a third constellation point set, to obtain a modulated symbol, where a plurality of constellation points in the third constellation point set are non-uniformly distributed, the third constellation point set is similar to a first constellation point set corresponding to a first modulation scheme, the first constellation point set is a subset of a second constellation point set, the second constellation point set is a set of a plurality of constellation points corresponding to a predefined second modulation scheme, an order of the second modulation scheme is higher than an order of the first modulation scheme, and an order of the third modulation scheme is the same as the order of the first modulation scheme.

It should be understood that, that the plurality of constellation points in the third constellation point set are non-uniformly distributed may be understood as follows: Every two adjacent constellation points in any coordinate direction in the third constellation point set are considered as one group of adjacent constellation points, and distances between constellation points in at least two groups of adjacent constellation points in the third constellation point set are different.

That the third constellation point set is similar to the first constellation point set may be understood as follows: A quantity of constellation points included in the third constellation point set is the same as a quantity of constellation points included in the first constellation point set, and the third constellation point set and the first constellation point set have a same quantity of constellation points in a same coordinate direction. If every two adjacent constellation points in a same constellation point set in a same coordinate direction are considered as one group of adjacent constellation points, a ratio of a distance between a group of adjacent constellation points at a first location in the first constellation point set to a distance between a group of adjacent constellation points at a first location in the third constellation point set is the same as a ratio of a distance between a group of adjacent constellation points at a second location in the first constellation point set to a distance between a group of adjacent constellation points at a second location in the third constellation point set.

It should be further understood that the plurality of constellation points in the second constellation point set may be uniformly distributed. In other words, if every two adjacent constellation points in any coordinate direction in the second constellation point set are considered as one group of adjacent constellation points, distances between constellation points in any two groups of adjacent constellation points in the second constellation point set may be the same.

In this application, because the plurality of constellation points in the third constellation point set are non-uniformly distributed, the third constellation point set is similar to the first constellation point set, and the first constellation point set is the subset of the second constellation point set, the process in which the to-be-transmitted bit sequence is modulated based on the third modulation scheme and then mapped to the constellation points in the third constellation point set is equivalent to geometric shaping, so that a shaping gain can be achieved. In addition, because the first constellation point set is the subset of the predefined second constellation point set, in this solution, the first constellation point set can be obtained from the predefined constellation point set by defining only one constellation point extraction manner. In this way, the third constellation point set is obtained, so that implementation complexity is low.

According to a second aspect, this application provides a communication method. The method may be applied to a second device. For example, the method may be performed by the second device, or may be performed by a component (for example, a chip or a chip system) configured in the second device, or may be implemented by a logical module or software that can implement all or some functions of the second device. This is not limited in this application.

For example, the method includes: receiving a modulated symbol, where the modulated symbol is obtained by mapping a bit sequence to each constellation point in a third constellation point set based on a third modulation scheme, a plurality of constellation points in the third constellation point set are non-uniformly distributed, the third constellation point set is similar to a first constellation point set corresponding to a first modulation scheme, the first constellation point set is a subset of a second constellation point set, the second constellation point set is a set of a plurality of constellation points corresponding to a predefined second modulation scheme, an order of the second modulation scheme is higher than an order of the first modulation scheme, and an order of the third modulation scheme is the same as the order of the first modulation scheme; and demodulating the modulated symbol, to obtain the bit sequence.

For descriptions of the first constellation point set and the second constellation point set, refer to the first aspect. Details are not described herein again.

In this application, because the plurality of constellation points in the third constellation point set are non-uniformly distributed, the third constellation point set is similar to the first constellation point set, and the first constellation point set is the subset of the second constellation point set, the process in which the to-be-transmitted bit sequence is modulated based on the third modulation scheme and then mapped to the constellation points in the third constellation point set is equivalent to geometric shaping, so that a shaping gain can be achieved. In addition, because the first constellation point set is the subset of the predefined second constellation point set, in this solution, the first constellation point set can be obtained from the predefined constellation point set by defining only one constellation point extraction manner, so that implementation complexity is low.

With reference to the first aspect and the second aspect, in some implementations, the third constellation point set is the same as the first constellation point set.

With reference to the first aspect and the second aspect, in some implementations, a location of each constellation point in the constellation point set corresponding to the first modulation scheme is determined based on a first mapping relationship, the first mapping relationship indicates a plurality of modulation schemes and a location of a constellation point corresponding to each modulation scheme, and the plurality of modulation schemes include the first modulation scheme.

It should be understood that the plurality of modulation schemes may include a plurality of modulation schemes with a same modulation order, or may include a plurality of modulation schemes with different modulation orders. A plurality of constellation points included in a constellation point set corresponding to each of the plurality of modulation schemes may be uniformly distributed, or may be non-uniformly distributed.

For example, the first mapping relationship includes a correspondence between the plurality of modulation schemes and a plurality of location coordinate sets, each location coordinate set includes a plurality of location coordinates, and each location coordinate identifies a location of one constellation point.

Because the first mapping relationship includes the correspondence between the plurality of modulation schemes and the plurality of location coordinate sets, the first device may determine, from the plurality of location coordinate sets based on the first modulation scheme and the first mapping relationship, a location coordinate set corresponding to the first modulation scheme, and a plurality of constellation points identified by the location coordinate set are constellation points in the first constellation point set.

For example, each constellation point in the second constellation point set corresponds to one sequence number, each sequence number identifies one constellation point in the second constellation point set, the first mapping relationship includes a correspondence between the plurality of modulation schemes and a plurality of sequence number sets, and each sequence number set includes a plurality of sequence numbers.

Because the first mapping relationship includes the correspondence between the plurality of modulation schemes and the plurality of sequence number sets, the first device may determine, from the plurality of sequence number sets based on the first modulation scheme and the first mapping relationship, a sequence number set corresponding to the first modulation scheme, and a constellation point identified by each sequence number in the sequence number set belongs to the first constellation point set.

With reference to the first aspect and the second aspect, in some implementations, in the plurality of modulation schemes, a plurality of constellation points in a constellation point set corresponding to each modulation scheme are symmetric with respect to an origin.

With reference to the first aspect and the second aspect, in some implementations, the second modulation scheme is 1024 quadrature amplitude modulation (quadrature amplitude modulation, QAM) or QAM of another order.

According to a third aspect, this application provides a communication method. The method may be applied to a first device. For example, the method may be performed by the first device, or may be performed by a component (for example, a chip or a chip system) configured in the first device, or may be implemented by a logical module or software that can implement all or some functions of the first device. This is not limited in this application.

For example, the method includes: receiving indication information, where the indication information indicates that parameters in a first modulation and coding scheme (modulation and coding scheme, MCS) table or a second MCS table are used for coding and modulation; and determining, based on the indication information, to encode and modulate a to-be-transmitted information bit sequence by using the first MCS table or the second MCS table.

It should be understood that the first MCS table in this application is designed for geometric shaping or probabilistic shaping. In this case, when a corresponding shaping technology is used, transmission performance achieved by using the first MCS table is better than transmission performance achieved by using the second MCS table.

With reference to the third aspect, in some implementations, the method further includes: encoding and modulating the information bit sequence by using the parameters in the first MCS table or the second MCS table, to obtain a modulated symbol; and sending the modulated symbol.

According to a fourth aspect, this application provides a communication method. The method may be applied to a second device. For example, the method may be performed by the second device, or may be performed by a component (for example, a chip or a chip system) configured in the second device, or may be implemented by a logical module or software that can implement all or some functions of the second device. This is not limited in this application.

For example, the method includes: generating indication information, where the indication information indicates that parameters in an MCS table or a second MCS table are used for coding and modulation; and sending the indication information.

For descriptions of the first MCS table and the second MCS table, refer to the third aspect. Details are not described herein again.

With reference to the fourth aspect, in some implementations, the method further includes: receiving a modulated symbol, where the modulated symbol is obtained by encoding and modulating a to-be-transmitted information bit sequence by using the parameters in the first MCS table or the second MCS table; and demodulating and decoding the modulated symbol, to obtain the information bit sequence.

With reference to the third aspect and the fourth aspect, in some implementations, there are different modulation orders in modulation orders corresponding to a same MCS index in the first MCS table and the second MCS table, and when the modulation orders are different, a corresponding modulation order in the first MCS table is higher than a corresponding modulation order in the second MCS table.

For example, in the first MCS table, a switching point at which a modulation order is switched from 2 to 4 is an MCS index 8, and a switching point at which a modulation order is switched from 4 to 6 is an MCS index 14. In the second MCS table, a switching point at which a modulation order is switched from 2 to 4 is an MCS index 10, and a switching point at which a modulation order is switched from 4 to 6 is an MCS index 17.

With reference to the third aspect and the fourth aspect, in some implementations, there are different modulation orders in modulation orders corresponding to a same spectral efficiency in the first MCS table and the second MCS table, and when the modulation orders are different, a corresponding modulation order in the first MCS table is higher than a corresponding modulation order in the second MCS table.

For example, in the second MCS table, a switching point at which a modulation order is switched from 2 to 4 is a spectral efficiency 1.3281, and a switching point at which a modulation order is switched from 4 to 6 is a spectral efficiency 2.5664. In the first MCS table, a switching point at which a modulation order is switched from 2 to 4 is a spectral efficiency 1.1758, and a switching point at which a modulation order is switched from 4 to 6 is a spectral efficiency 2.1621.

It can be learned that a modulation order switching point in the first MCS table occurs ahead of a modulation order switching point in the second MCS table.

According to a fifth aspect, this application provides a communication apparatus, including a module or a unit configured to implement the method according to any one of the aspects and any possible implementation of any one of the aspects. It should be understood that each module or unit may implement a corresponding function by executing a computer program.

According to a sixth aspect, this application provides another communication apparatus, including a processor. The processor is configured to perform the method according to any one of the aspects and any possible implementation of any one of the aspects.

The apparatus may further include a memory configured to store instructions and data. The memory is coupled to the processor. When executing the instructions stored in the memory, the processor can implement the method described in the aspects.

The apparatus may further include a communication interface. The communication interface is used by the apparatus to communicate with another device. For example, the communication interface may be a transceiver, a circuit, a bus, a module, or another type of communication interface.

According to a seventh aspect, this application provides a chip system. The chip system includes at least one processor configured to support implementation of functions in any one of the aspects and any possible implementation of any one of the aspects, for example, receiving or processing data and/or information in the foregoing method.

In a possible design, the chip system further includes a memory. The memory is configured to store program instructions and data, and the memory is located inside or outside the processor.

The chip system may include a chip, or may include a chip and another discrete component.

According to an eighth aspect, this application provides a computer-readable storage medium, including a computer program. When the computer program is run on a computer, the computer is enabled to implement the method according to any one of the aspects and any possible implementation of any one of the aspects.

According to a ninth aspect, this application provides a computer program product. The computer program product includes a computer program (which may also be referred to as code or instructions). When the computer program is run, a computer is enabled to perform the method according to any one of the aspects and any possible implementation of any one of the aspects.

According to a tenth aspect, this application provides a communication system, including the foregoing first device and second device.

It should be understood that technical solutions of the fifth aspect to the tenth aspect of this application correspond to technical solutions of the first aspect to the fourth aspect of this application, and beneficial effects achieved in the aspects and corresponding feasible implementations are similar. Details are not described again.

### BRIEF DESCRIPTION OF DRAWINGS

FIG. 1 is a diagram of an architecture of a communication system to which a method according to an embodiment of this application is applied;
FIG. 2 is a diagram of a signal processing process according to an embodiment of this application;
FIG. 3 is a diagram of distribution of constellation points of QAM modulation;
FIG. 4 is a diagram of distribution of constellation points of APSK modulation;
FIG. 5 and FIG. 6 are schematic flowcharts of communication methods according to embodiments of this application; and
FIG. 7 and FIG. 8 are block diagrams of communication apparatuses according to embodiments of this application.

### DESCRIPTION OF EMBODIMENTS

The following describes technical solutions of this application with reference to accompanying drawings.

The technical solutions provided in this application may be applied to various communication systems, such as a long term evolution (long term evolution, LTE) system, an LTE frequency division duplex (frequency division duplex, FDD) system, LTE time division duplex (time division duplex, TDD), a sidelink (sidelink, SL) communication system, a worldwide interoperability for microwave access (worldwide interoperability for microwave access, WiMAX) communication system, a 5th generation (5th generation, 5G) mobile communication system or a new radio access technology (new radio access technology, NR), and a satellite communication system. The 5G mobile communication system may include non-standalone (non-standalone, NSA) networking and/or standalone (standalone, SA) networking.

The technical solutions provided in this application may be further applied to a future communication system, for example, a 6th generation (6th generation, 6G) mobile communication system. This is not limited in this application.

The technical solutions provided in this application may be further applied to service scenarios such as backscattering communication and passive internet-of-things communication in the NR communication system.

A radio access network (radio access network, RAN) device in this application is a device having a wireless transceiver function. The radio access network device may provide a wireless communication function service, and may connect a terminal to a radio network. The radio access network device may be a node in the radio access network, referred to as a RAN node for short.

In a possible scenario, the RAN node may be a base station (base station, BS), an evolved NodeB (evolved NodeB, eNodeB), a transmission reception point (transmission reception point, TRP), a home evolved NodeB (home evolved NodeB or home NodeB, HNB), an access point (access point, AP) of wireless fidelity (wireless fidelity, Wi-Fi), a mobile switching center, a next generation NodeB (next generation NodeB, gNB) in a 5G mobile communication system, a next generation base station in a 6G mobile communication system, a base station in a future mobile communication system, or the like. Alternatively, the RAN node may be a device that functions as a base station in a device-to-device (device-to-device, D2D) communication system, a vehicle-to-everything (vehicle-to-everything, V2X) communication system, a machine-to-machine (machine-to-machine, M2M) communication system, or an internet of things (internet to things, IoT) communication system. Alternatively, the RAN node may be a RAN node in a non-terrestrial network (non-terrestrial network, NTN). In other words, the RAN node may be deployed on a high-altitude platform or a satellite. The RAN node may be a macro base station, or may be a micro base station or an indoor base station, or may be a relay node, a donor node, or the like, or may be a radio controller in a cloud radio access network (cloud radio access network, CRAN) scenario, a node in an open radio access network (open radio access network, O-RAN or ORAN) scenario, or the like. Optionally, the RAN node may alternatively be a server, a wearable device, a vehicle, a vehicle-mounted device, or the like. For example, a RAN node in a V2X technology may be a road side unit (road side unit, RSU). Certainly, the RAN node may alternatively be a node in a core network.

In another possible scenario, a plurality of RAN nodes coordinate to assist the terminal in implementing radio access, and different RAN nodes respectively implement some functions of a base station. For example, the RAN node may be a central unit (central unit, CU), a distributed unit (distributed unit, DU), a CU-control plane (control plane, CP), a CU-user plane (user plane, UP), a radio unit (radio unit, RU), or the like. The CU and the DU may be separately arranged, or may be included in a same network element, for example, a baseband unit (baseband unit, BBU). The RU may be included in a radio frequency device or a radio frequency unit, for example, included in a remote radio unit (remote radio unit, RRU), an active antenna processing unit (active antenna unit, AAU), or a remote radio head (remote radio head, RRH).

In different systems, the CU (or the CU-CP and the CU-UP), the DU, or the RU may have different names, but a person skilled in the art may understand a meaning of the name. For example, in an ORAN system, the CU may also be referred to as an open CU (O-CU), the DU may also be referred to as an open DU (O-DU), the CU-CP may also be referred to as an open CU-CP (O-CU-CP), the CU-UP may also be referred to as an open CU-UP (O-CU-UP), and the RU may also be referred to as an open RU (O-RU).

Any one of the CU (or the CU-CP or the CU-UP), the DU, and the RU may be implemented by using a software module, a hardware module, or a combination of a software module and a hardware module. In other words, the radio access network device in this application may be a virtualized device, for example, implemented by using general-purpose hardware and an instantiated virtualization function, or by using dedicated hardware and an instantiated virtualization function. The general-purpose hardware may be a server, for example, a cloud server.

A terminal device in this application may also be referred to as user equipment (user equipment, UE), an access terminal, a subscriber unit, a subscriber station, a mobile station, a mobile console, a remote station, a remote terminal, a mobile device, a user terminal, a terminal, a wireless communication device, a user agent, or a user apparatus.

The terminal device may be a device that provides voice/data connectivity for a user, for example, a handheld device or a vehicle-mounted device that has a wireless connection function. Currently, some examples of the terminal device may be: a mobile phone (mobile phone), a tablet computer (pad), a computer (for example, a notebook computer or a palmtop computer) having a wireless transceiver function, a mobile internet device (mobile internet device, MID), a virtual reality (virtual reality, VR) device, an augmented reality (augmented reality, AR) device, a wireless terminal in industrial control (industrial control), a wireless terminal in self-driving (self-driving), an uncrewed aerial vehicle, a wireless terminal in telemedicine (remote medical), a wireless terminal in a smart grid (smart grid), a wireless terminal in transportation safety (transportation safety), a wireless terminal in a smart city (smart city), a wireless terminal in a smart home (smart home), a cellular phone, a cordless phone, a session initiation protocol (session initiation protocol, SIP) phone, a wireless local loop (wireless local loop, WLL) station, a personal digital assistant (personal digital assistant, PDA), a handheld device having a wireless communication function, a computing device, another processing device connected to a wireless modem, a vehicle-mounted device, a wearable device, a terminal device in a 5G network, a terminal device in a future evolved public land mobile network (public land mobile network, PLMN), and the like.

The wearable device may also be referred to as a wearable intelligent device, and is a general term of wearable devices, such as glasses, gloves, watches, clothes, and shoes, that are developed by applying wearable technologies to intelligent designs of daily wear. The wearable device is a portable device that can be directly worn on the body or integrated into clothes or an accessory of the user. The wearable device is not only a hardware device, but also implements a powerful function through software support, data exchange, and cloud interaction. In a broad sense, wearable intelligent devices include full-featured and large-sized devices that can implement complete or partial functions without depending on smartphones, such as smart watches or smart glasses, and devices that dedicated to only one type of application function and need to work with other devices such as smartphones, such as various smart bands or smart jewelry for monitoring physical signs.

In addition, the terminal device may alternatively be a terminal device in an IoT system. IoT is an important part in future development of an information technology. A main technical feature of the IoT is to connect things to a network by using a communication technology, to implement an intelligent network for human-machine interconnection and thing-thing interconnection. The IoT technology can achieve massive connections, deep coverage, and terminal power saving by using, for example, a narrowband (narrowband, NB) technology.

The terminal device may further include sensors such as an intelligent printer, a train detector, and a gas station, and main functions include: collecting data (which is a function of some terminal devices), receiving control information and downlink data of a network device, sending an electromagnetic wave, and transmitting uplink data to the network device.

The terminal device may be a virtualized device, for example, implemented by using general-purpose hardware and an instantiated virtualization function, or by using dedicated hardware and an instantiated virtualization function. The general-purpose hardware may be a server, for example, a cloud server.

The terminal device may be a passive terminal device including an envelope detector receiver, a passive IoT terminal device, a semi-passive terminal device, a semi-passive IoT terminal device, a terminal device having a backscattering capability, an NR terminal device, an NR base station/pole site/micro base station/small cell, a reader/writer terminal device, or the like.

It should be understood that specific forms of the radio access network device and the terminal device are not limited in this application.

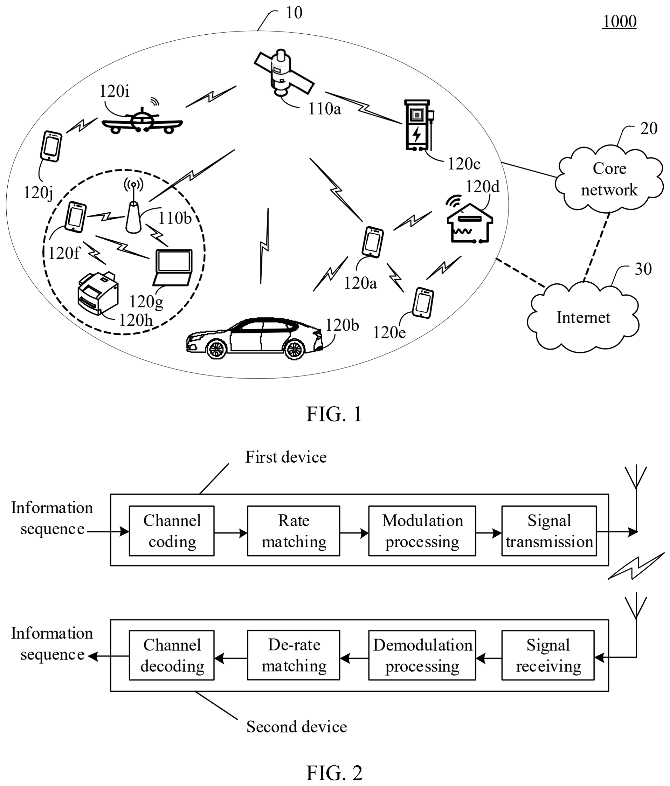

FIG. 1 is a diagram of an architecture of a communication system 1000 to which a method according to an embodiment of this application is applied. As shown in FIG. 1, the communication system 1000 includes a radio access network 10 and a core network 20. Optionally, the communication system 1000 may further include the internet 30. The radio access network 10 may include at least one radio access network device (for example, 110a and 110b in FIG. 1), and may further include at least one terminal (for example, 120a to 120j in FIG. 1).

The terminal may be connected to the radio access network device in a wireless manner, and the radio access network device may be connected to the core network in a wireless or wired manner. A core network device and a radio access network device may be different independent physical devices, or functions of the core network device and logical functions of the radio access network device may be integrated into a same physical device, or some functions of the core network device and some functions of the radio access network device may be integrated into one physical device. A wired or wireless manner may be used for connection between terminals and between radio access network devices.

Communication between a radio access network device and a terminal, between radio access network devices, and between terminals may be performed by using a licensed spectrum, an unlicensed spectrum, or both a licensed spectrum and an unlicensed spectrum; and may be performed by using a spectrum below 6 gigahertz (gigahertz, GHz), a spectrum above 6 GHz, or both a spectrum below 6 GHz and a spectrum above 6 GHz. A spectrum resource used for wireless communication is not limited in embodiments of this application.

The radio access network device may be a base station deployed in the air, for example, may be a satellite base station 110a; or may be a base station deployed indoors, for example, may be a micro base station or indoor base station 110b.

The terminal may be a terminal deployed in the air, for example, a helicopter or uncrewed aerial vehicle 120i in FIG. 1; or may be a terminal deployed on the ground, for example, a mobile phone 120a, a mobile phone 120e, a mobile phone 120f, a mobile phone 120j, a vehicle 120b, a computer 120g, or a printer 120h in FIG. 1.

The radio access network device and the terminal may be at fixed positions, or may move. For example, the radio access network device and the terminal may be deployed on land, including an indoor device, an outdoor device, a handheld device, or a vehicle-mounted device; or may be deployed on water; or may be deployed on an airplane, a balloon, or an artificial satellite in the air.

Roles of the radio access network device and the terminal may be relative. For example, the helicopter or uncrewed aerial vehicle 120i in FIG. 1 may be configured as a mobile base station. For 120j that accesses the radio access network 100 via 120i, 120i is a base station, while for 110a, 120i is a terminal, that is, 110a and 120i communicate with each other according to a radio air interface protocol. Certainly, 110a and 120i may alternatively communicate with each other according to an interface protocol between radio access network devices. In this case, for 110a, 120i is also a base station. Therefore, both the radio access network device and the terminal device may be collectively referred to as a communication device. 110a, 110b, and 120a to 120j in FIG. 1 may be referred to as communication devices having respective corresponding functions, for example, a communication device having a base station function or a communication device having a terminal function.

It should be understood that, FIG. 1 is merely a diagram. The communication system may further include other devices, for example, may further include a wireless relay device and a wireless backhaul device, which are not shown in FIG. 1.

With reference to FIG. 2, the following briefly describes a process of processing to-be-transmitted data at a physical layer when data communication is performed between an access network device and a terminal device. It should be understood that the signal processing process shown in FIG. 2 may be performed by the access network device, or may be performed by the terminal device. This is not limited in this application.

As shown in FIG. 2, when sending information data, a first device (for example, the access network device or the terminal device shown in FIG. 1) may segment an information sequence from an upper layer (for example, a media access control (media access control, MAC) layer) into a plurality of transport blocks (transport blocks, TBs) based on a transport block size supported by a system, and add cyclic redundancy check (cyclic redundancy check, CRC) check bits *p*₀*, p*₁, *p*₂, *p*₃,..., *p*_{*L-*1} of a same length to each transport block *a*₀*, a*₁, *a*₂, *a*₃,..., *a*_{*A-*1}, to obtain a sequence *b*₀*,b*₁,*b*₂,*b*₃,...,*b*_{*B-*1} (that is, A+L=B, where when A is a bit length of a transport block a₀, L is a length of P₀, and B is a bit length of a sequence b₀), where the obtained sequence *b*₀*,b*₁,*b*₂,*b*₃,...,*b*_{*B-*1} may be referred to as a to-be-transmitted TB.

It should be understood that the foregoing process of adding CRC check of the same length to each transport block *a*₀*,a*₁,*a*₂,*a*₃,...,*a*_{*A-*1} may be an optional step. When the process of adding the CRC check to each transport block is not included, a transport block *a*₀*,a*₁,*a*₂,*a*₃,...,*a*_{*A-*1} obtained through segmentation may also be referred to as a to-be-transmitted TB.

If a size of the transport block *b*₀*,b*₁,*b*₂,*b*₃,...,*b*_{*B-*1} to which the check is added exceeds a preset segmentation length of channel coding, the transport block needs to be divided into several code blocks (code blocks, CBs). Each code block (where each code block may be a to-be-transmitted information bit sequence in this application) may include several bits in the transport block, and may further include CRC check bits of these bits. Then, the first device may perform channel coding on each code block, for example, perform low-density parity-check code (low-density parity-check code, LDPC) coding or polar (Polar) coding, to obtain a corresponding coded code block. Each coded code block may include a plurality of information bits before coding and check bits generated through coding in the code block.

The first device may store the coded bit sequence in a circular buffer of the first device for rate matching. The first communication device may select a segment of coded bits (where the segment of coded bits may be a to-be-transmitted bit sequence in this application) from the circular buffer, perform modulation processing, map the segment of coded bits to a modulated symbol, and send a signal including the modulated symbol.

The second device performs demodulation processing on the received modulated symbol, and may store a soft value of the received coded bit at a corresponding location in a soft information buffer. If retransmission occurs, the second device combines soft values of coded bits in each time of retransmission and stores the soft values in the soft information buffer. The combination herein means that if locations of coded bits received twice are the same, soft values of the coded bits received twice are combined.

The second device may directly decode all soft values in the soft information buffer, for example, perform LDPC decoding or polar decoding, to obtain a corresponding information sequence. The information sequence obtained through channel decoding may be sent to an upper layer (for example, a MAC layer).

It should be understood that a process in which the second device processes the received modulated symbol to obtain the information sequence may be considered as an inverse process of a process in which the first device processes the to-be-sent information data to obtain the coded bit sequence.

A spectral efficiency can be further improved through high-order modulation. In high-order modulation, because different symbols have different energy, an objective of saving average energy can be achieved by sending more low-energy symbols and fewer high-energy symbols. Theoretic analysis shows that for a white Gaussian noise channel, mutual information per unit energy is maximized when distribution of sent symbols follows Gaussian distribution. Compared with uniform distribution, the Gaussian distribution provides a theoretical performance gain of approximately 1.53 decibels (decibel, dB).

To improve transmission performance, currently, the following two implementations are used.

Method 1: Geometric shaping: Equal-probability distribution of input symbols is maintained, but constellation points are specially designed. Low-energy constellation points are densely distributed, and high-energy constellation points are sparsely distributed.

Method 2: Probabilistic shaping: Constellation distribution remains unchanged, but probabilities of constellation points are adjusted. A low-energy symbol has a higher probability, and a high-energy symbol has a lower probability.

The foregoing two methods have respective advantages and disadvantages during application. Probabilistic shaping usually requires a complex distribution matcher (distribution matcher), so that a larger modification to a coding and modulation procedure is required, but a larger performance gain is achieved. In contrast, geometric shaping requires a smaller modification to a coding procedure. Therefore, a specific gain can be achieved at low implementation complexity costs.

Currently, a QAM modulation scheme in an existing standard specifies 4QAM, 16QAM, 256QAM, ..., 1024QAM, and the like. 4QAM may be considered as a complex number symbol (-1+1i, -1-1i, 1+1i, 1-1i), where both a real part and an imaginary part are binary phase shift keying (binary phase shift keying, BPSK) modulation. A real number symbol of 16QAM is (-3-3i, -3-1i, -3+1i, -3+3i, -1-3i, -1-1i, -1+1i, -1+3i, 1-3i, 1-1i, 1+1i, 1+3i, 3-3i, 3-1i, 3+1i, 3+3i), where both a real part and an imaginary part are 4 amplitude shift keying (amplitude shift keying, ASK) modulation. As shown in FIG. 2, when a QAM modulation scheme provided in a current standard is used for modulation, constellation points of lower-order modulation are a subset of constellation points of high-order modulation. For example, constellation points of 64QAM is a subset of constellation points of 256QAM.

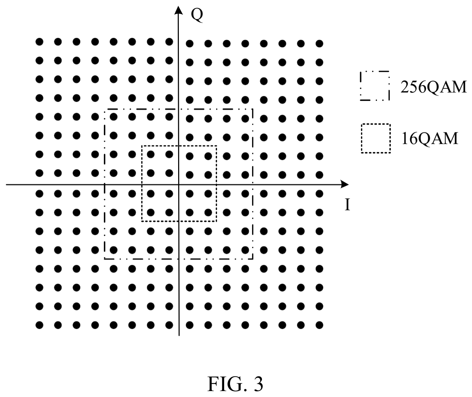

It can be learned from FIG. 3 that, a plurality of constellation points corresponding to QAM modulation schemes of different orders in a constellation diagram are uniformly distributed. In other words, if every two adjacent constellation points in any row or column of a plurality of constellation points corresponding to QAM of a same order are considered as one group of adjacent constellation points, distances between constellation points in any two groups of adjacent constellation points in the plurality of constellation points are the same.

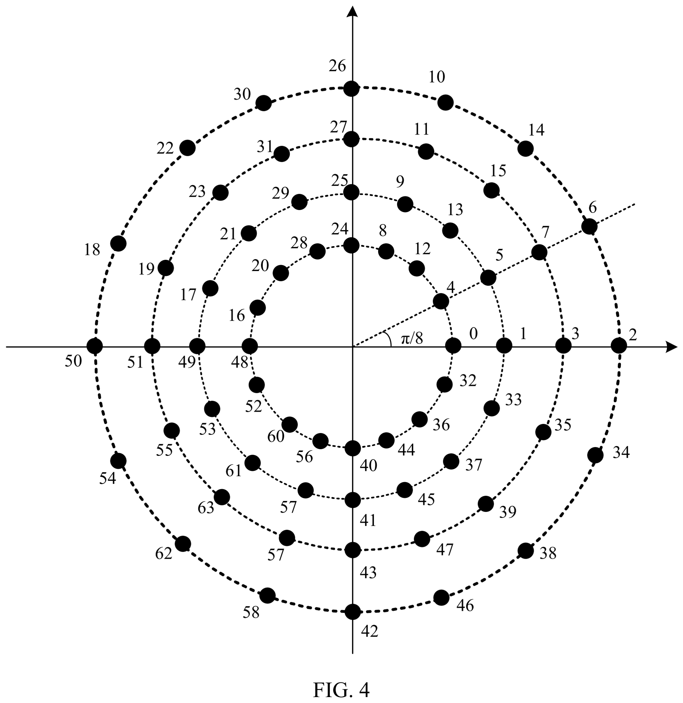

To achieve a gain of geometric shaping, it is proposed in the related technology to use amplitude phase shift keying (amplitude phase shift keying, APSK) as a basic framework and optimize distribution of constellation points, to achieve the shaping gain. It can be learned from constellation points shown in FIG. 4 that the constellation points in this solution are irregular, and real parts and imaginary parts are not independent, resulting in high demodulation complexity.

In view of this, this application proposes a communication method and a related apparatus. In the method, some constellation points are non-uniformly extracted in a constellation point set corresponding to a QAM modulation scheme defined in an existing standard, to form a low-order QAM modulation scheme for modulating a to-be-transmitted bit sequence. According to this scheme, a shaping gain can be achieved, and real parts and imaginary parts are independent of each other, thereby ensuring low demodulation complexity.

For ease of understanding of embodiments of this application, the following descriptions are first provided.

First, in embodiments of this application, prefix words such as "first" and "second" are merely used for distinguishing and describing different things belonging to a same name category, and are not intended to limit a sequence, sizes, or a quantity of things. For example, a "first modulation scheme" and a "second modulation scheme" are merely different modulation schemes, and there is no time sequence relationship or priority relationship between the two modulation schemes.

Second, "sending" and "receiving" in embodiments of this application indicate a signal transmission direction. For example, "sending indication information" may be understood as that a destination end of the information is a terminal device, and may include direct sending through an air interface, or indirect sending performed by another unit or module through the air interface. "Receiving indication information" may be understood as that a source end of the configuration information is a network device, and may include direct receiving from the network device through an air interface, or indirect receiving from the network device from another unit or module through the air interface. "Sending" may alternatively be understood as "outputting" of a chip interface, and "receiving" may alternatively be understood as "inputting" of a chip interface.

In other words, sending and receiving may be performed between devices, for example, between a terminal device and a network device; or may be performed inside a device, for example, sending or receiving between components, modules, chips, software modules, or hardware modules inside the device through a bus, a cable, or an interface.

It may be understood that, before the information is sent from the source end to the destination end, necessary processing such as coding and modulation may be performed on the information. After receiving the information from the source end, the destination end may perform corresponding processing such as decoding and demodulation, to interpret valid information from the source end. Similar descriptions in this application may be understood similarly. Details are not described again.

Third, in embodiments of this application, "at least one" means one or more, and "a plurality of" means two or more. The term "and/or" describes an association relationship between associated objects, and represents that three relationships may exist. For example, A and/or B may represent the following cases: Only A exists, both A and B exist, and only B exists, where A and B may be singular or plural. The character "/" usually represents an "or" relationship between the associated objects, but does not exclude an "and" relationship between the associated objects. A specific meaning represented by the character "/" may be understood with reference to the context. "At least one of the following items (pieces)" or a similar expression thereof indicates any combination of these items, including a single item (piece) or any combination of a plurality of items (pieces). For example, at least one item (piece) of a, b, or c may indicate a, b, c, a and b, a and c, b and c, or a, b, and c, where a, b, and c may be singular or plural.

Fourth, in embodiments of this application, "indication" may include direct indication and indirect indication, or may include explicit indication and implicit indication. Information indicated by specific information (for example, the following first information) is referred to as to-be-indicated information. In a specific implementation process, the to-be-indicated information may be indicated in a plurality of manners, for example, but not limited to, directly indicating the to-be-indicated information, for example, indicating the to-be-indicated information or an index of the to-be-indicated information. Alternatively, the to-be-indicated information may be indirectly indicated by indicating other information. There is an association relationship between the other information and the to-be-indicated information. Alternatively, only a part of the to-be-indicated information may be indicated, and the remaining part of the to-be-indicated information is known or pre-agreed on. For example, specific information may alternatively be indicated by using an arrangement sequence of pieces of information that are pre-agreed on (for example, predefined in a protocol), to reduce indication overheads to some extent. A specific indication manner is not limited in this application.

It may be understood that, for a sender of the indication information, the indication information may indicate to-be-indicated information, and for a receiver of the indication information, the indication information may be for determining to-be-indicated information.

Fifth, in embodiments of this application, descriptions such as "when...", "in a case of...", "if", and "if" all mean that a device (for example, a network device or a terminal device) performs corresponding processing in an objective case, and are not limited to a time, and the device (for example, the network device or the terminal device) is not required to perform a determining action during implementation. This does not mean that there is another limitation.

Sixth, storage in this application may mean storage in one or more memories. The one or more memories may be separately disposed, or may be integrated into an encoder or a decoder, a processor, or a communication apparatus. Alternatively, a part of the one or more memories may be separately disposed, and a part of the one or more memories are integrated into the decoder, the processor, or the communication apparatus. A type of the memory may be a storage medium in any form. This is not limited in this application.

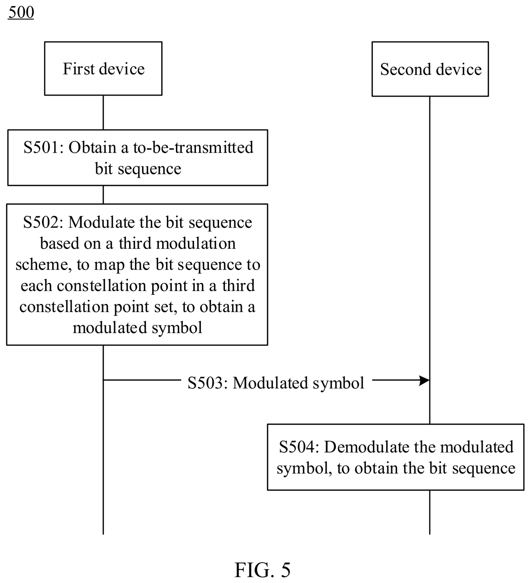

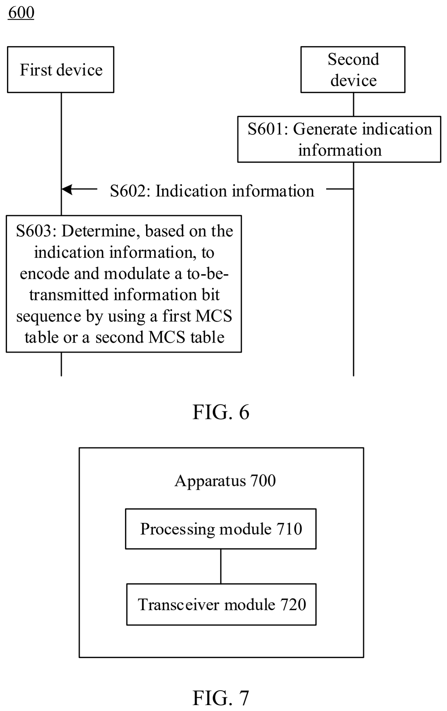

With reference to FIG. 5 and FIG. 6, the following describes in detail a method provided in an embodiment of this application. The method may be applied to the communication system shown in FIG. 1. However, this embodiment of this application is not limited thereto.

In a flowchart shown in FIG. 5, the method is shown from a perspective of interaction between communication devices. However, an execution body of the method is not limited in this application. For example, a first device in FIG. 5 may be a network device, or may be a terminal device, or may be a chip, a chip system, or a processor that can support the first device in implementing the method, or may be a logical module or software that can implement all or some functions of the first device; and a second device in FIG. 5 may be a network device, or may be a terminal device, or may be a chip, a chip system, or a processor that can support the second device in implementing the method, or may be a logical module or software that can implement all or some functions of the second device.

FIG. 5 is a schematic flowchart of a communication method 500 according to an embodiment of this application. As shown in FIG. 5, the method 500 may include S501 to S504. The following describes in detail steps shown in FIG. 5.

S501: The first device obtains a to-be-transmitted bit sequence.

The to-be-transmitted bit sequence in this application may be a sequence obtained after channel coding and rate matching are performed on to-be-transmitted information. For a process of obtaining the bit sequence, refer to the foregoing descriptions. Details are not described herein again.

S502: The first device modulates the bit sequence based on a third modulation scheme, to map the bit sequence to each constellation point in a third constellation point set, to obtain a modulated symbol.

A plurality of constellation points in the third constellation point set are non-uniformly distributed, the third constellation point set is similar to a first constellation point set corresponding to a first modulation scheme, the first constellation point set is a subset of a second constellation point set, the second constellation point set is a set of a plurality of constellation points corresponding to a predefined second modulation scheme, an order of the second modulation scheme is higher than an order of the first modulation scheme, and an order of the third modulation scheme is the same as the order of the first modulation scheme. However, it should be noted that the third constellation point set may not be a subset of the second constellation point set.

That the plurality of constellation points in the third constellation point set are non-uniformly distributed may be understood as follows: Every two adjacent constellation points in any coordinate direction in the third constellation point set are considered as one group of adjacent constellation points, and distances between constellation points in at least two groups of adjacent constellation points in the third constellation point set are different. For example, in the plurality of constellation points in the third constellation point set, low-energy constellation points are densely distributed, and high-energy constellation points are sparsely distributed.

That the third constellation point set is similar to the first constellation point set may be understood as follows: A quantity of constellation points included in the third constellation point set is the same as a quantity of constellation points included in the first constellation point set, and the third constellation point set and the first constellation point set have a same quantity of constellation points in a same coordinate direction. If every two adjacent constellation points in a same constellation point set in a same coordinate direction are considered as one group of adjacent constellation points, a ratio of a distance between a group of adjacent constellation points at a first location in the first constellation point set to a distance between a group of adjacent constellation points at a first location in the third constellation point set is the same as a ratio of a distance between a group of adjacent constellation points at a second location in the first constellation point set to a distance between a group of adjacent constellation points at a second location in the third constellation point set.

Optionally, the third constellation point set may be the same as the first constellation point set.

It should be understood that a plurality of constellation points in the second constellation point set corresponding to the predefined second modulation scheme may be uniformly distributed. For descriptions of uniform distribution, refer to the foregoing related descriptions with reference to FIG. 3. Details are not described herein again.

For example, the second modulation scheme may be a QAM modulation scheme defined in an existing standard, for example, 1024QAM or another higher-order QAM modulation scheme defined in the existing standard. If the second modulation scheme is predefined 1024QAM, the second constellation point set includes 1024 uniformly distributed constellation points.

Because the order of the second modulation scheme is higher than the order of the first modulation scheme, the order of the first modulation scheme needs to be less than 1024. For example, the first modulation scheme may be 4QAM, 16QAM, 64QAM, or 256QAM. If the first modulation scheme is 4QAM, the first constellation point set may be four constellation points extracted from the second constellation point set in a non-uniform extraction manner. If the first modulation scheme is 16QAM, the first constellation point set may be 16 constellation points extracted from the second constellation point set in a non-uniform extraction manner. If the first modulation scheme is 64QAM, the first constellation point set may be 64 constellation points extracted from the second constellation point set in a non-uniform extraction manner. If the first modulation scheme is 256QAM, the first constellation point set may be 256 constellation points extracted from the second constellation point set in a non-uniform extraction manner.

For example, that the first device modulates the bit sequence based on the first modulation scheme may include: The first device modulates the bit sequence based on a correspondence between each constellation point in the first constellation point set corresponding to the first modulation scheme and the bit sequence. For a specific modulation process, refer to the foregoing descriptions. Details are not described herein again.

S503: The first device sends the modulated symbol to the second device. Correspondingly, the second device receives the modulated symbol from the first device.

S504: Demodulate the modulated symbol, to obtain the bit sequence.

It should be understood that a process of demodulating the modulated symbol is an inverse process of modulating the bit sequence. For a process of demodulating the modulated symbol, refer to the foregoing descriptions. Details are not described herein again.

In this embodiment of this application, because the plurality of constellation points in the third constellation point set are non-uniformly distributed, the third constellation point set is similar to the first constellation point set, and the first constellation point set is the subset of the second constellation point set, the process in which the to-be-transmitted bit sequence is modulated based on the third modulation scheme and then mapped to the constellation points in the third constellation point set is equivalent to geometric shaping, so that a shaping gain can be achieved. In addition, because the first constellation point set is the subset of the predefined second constellation point set, in this solution, the first constellation point set can be obtained from the predefined constellation point set by defining only one constellation point extraction manner, so that implementation complexity is low. Optionally, a location of each constellation point in the constellation point set corresponding to the first modulation scheme may be determined based on a first mapping relationship.

The first mapping relationship indicates a plurality of modulation schemes and a location of a constellation point corresponding to each modulation scheme, and the plurality of modulation schemes include the first modulation scheme.

It should be understood that the plurality of modulation schemes may include a plurality of modulation schemes with a same modulation order, or may include a plurality of modulation schemes with different modulation orders. For example, a modulation order of 16QAM is 4, the modulation order 4 may correspond to a plurality of modulation schemes, and different modulation schemes correspond to different constellation point locations. For another example, a modulation order of 16QAM is 4, a modulation order of 64QAM is 8, the modulation order 4 and the modulation order 8 may correspond to at least two modulation schemes, and the two modulation schemes correspond to different constellation point locations. A plurality of constellation points included in each of a plurality of constellation point sets corresponding to 16QAM and 64QAM are non-uniformly distributed, and the plurality of constellation point sets each may be a subset of a constellation point set corresponding to a predefined QAM modulation scheme (for example, 1024QAM) whose modulation order is greater than 8.

For example, the first mapping relationship includes a correspondence between the plurality of modulation schemes and a plurality of location coordinate sets, each location coordinate set includes a plurality of location coordinates, and each location coordinate identifies a location of one constellation point.

Because the first mapping relationship includes the correspondence between the plurality of modulation schemes and the plurality of location coordinate sets, the first device may determine, from the plurality of location coordinate sets based on the first modulation scheme and the first mapping relationship, a location coordinate set corresponding to the first modulation scheme, and a plurality of constellation points identified by the location coordinate set are constellation points in the first constellation point set.

For example, each constellation point in the second constellation point set corresponds to one sequence number, each sequence number identifies one constellation point in the second constellation point set, the first mapping relationship includes a correspondence between the plurality of modulation schemes and a plurality of sequence number sets, and each sequence number set includes a plurality of sequence numbers.

In this application, the plurality of constellation points in the second constellation point set are sequentially numbered, so that each constellation point may correspond to one sequence number, and different constellation points correspond to different sequence numbers. Because the first constellation point set corresponding to the first modulation scheme is the subset of the second constellation point set corresponding to the second modulation scheme, the constellation points in the first constellation point set may be identified by using the sequence numbers corresponding to the constellation points.

Because the first mapping relationship includes the correspondence between the plurality of modulation schemes and the plurality of sequence number sets, the first device may determine, from the plurality of sequence number sets based on the first modulation scheme and the first mapping relationship, a sequence number set corresponding to the first modulation scheme, and a constellation point identified by each sequence number in the sequence number set belongs to the first constellation point set.

**Table 1**

| MCS index (index) I_{MCS} | Modulation order (modulation order) Qₘ | Target code rate (target code rate) | Constellation point set | Spectral efficiency (spectral efficiency) |
|---|---|---|---|---|
| 0 | 2 | 120 | [-1 1] | 0.2344 |
| 1 | 2 | 157 | [-1 1] | 0.3066 |
| 2 | 2 | 193 | [-1 1] | 0.3770 |
| 3 | 2 | 251 | [-1 1] | 0.4902 |
| 4 | 2 | 308 | [-1 1] | 0.6016 |
| 5 | 2 | 379 | [-1 1] | 0.7402 |
| 6 | 2 | 449 | [-1 1] | 0.8770 |
| 7 | 2 | 526 | [-1 1] | 1.0273 |
| 8 | 2 | 602 | [-1 1] | 1.1758 |
| 9 | 2 | 679 | [-1 1] | 1.3262 |
| 10 | 4 | 340 | [-21 -10 10 21] | 1.3281 |
| 11 | 4 | 378 | [-27 -9 9 27] | 1.4766 |
| 12 | 4 | 434 | [-15 -5 5 15] | 1.6953 |
| 13 | 4 | 490 | [-11 -3 3 11] | 1.9141 |
| 14 | 4 | 553 | [-19 -5 5 19] | 2.1602 |
| 15 | 4 | 616 | [-17 -5 5 17] | 2.4063 |
| 16 | 4 | 658 | [-17 -5 5 17] | 2.5703 |
| 17 | 6 | 438 | [-21 -13 -7 -3 3 7 13 21] | 2.5664 |
| 18 | 6 | 466 | [-21 -13 -7 -3 3 7 13 21] | 2.7305 |
| 19 | 6 | 517 | [-27 -17 -9-3 3 9 17 27] | 3.0293 |
| 20 | 6 | 567 | [-27 -17 -9 -3 3 9 17 27] | 3.3223 |
| 21 | 6 | 616 | [-27 -17 -9-3 3 9 17 27] | 3.6094 |
| 22 | 6 | 666 | [-27 -17 -9 -3 3 9 17 27] | 3.9023 |
| 23 | 6 | 719 | [-23 -15 -9 -3 3 9 15 23] | 4.2129 |
| 24 | 6 | 772 | [-23 -15 -9 -3 3 9 15 23] | 4.5234 |
| 25 | 6 | 822 | [-23 -15 -9 -3 3 9 15 23] | 4.8164 |
| 26 | 6 | 873 | [-23 -15 -9 -3 3 9 15 23] | 5.1152 |
| 27 | 6 | 909 | [-23 -15 -9 -3 3 9 15 23] | 5.3320 |
| 28 | 8 | 711 | [-19 -15 -11 -9 -7 -5 -3 -1 1 3 5 7 9 11 15 19] | 5.5547 |
| 29 | 2 | Reserved (reserved) | | |
| 30 | 4 | Reserved | | |
| 31 | 6 | Reserved | | |

Table 1 shows the first mapping relationship. As shown in Table 1, constellation point sets corresponding to a modulation order 2 to a modulation order 8 are all subsets of a constellation point set corresponding to a modulation order 10. The modulation order 2 is a modulation order corresponding to 4QAM, the modulation order 8 is a modulation order corresponding to 256QAM, and the modulation order 10 is a modulation order corresponding to 1024QAM. Each MCS index may be considered as a modulation scheme in this application, and each MCS index corresponds to a constellation point location set (namely, a constellation point location column).

In addition, Table 1 further includes a target code rate, a spectral efficiency, and the like that correspond to each modulation scheme.

Each group of values shown in the column of constellation point sets in Table 1 may be used to determine locations of a plurality of constellation points. Specifically, each group of values includes a plurality of values. A value of a real part of a constellation point corresponding to each group of values may be obtained by traversing each of the plurality of values. A value of an imaginary part of a constellation point corresponding to each group of data may be obtained by traversing each of the plurality of values. Different values of the real part and different values of the imaginary part are combined, so that locations of the plurality of constellation points corresponding to each group of values can be obtained. For example, if a group of values is [a b c d], four values a, b, c, and d of the real part and four values ai, bi, ci, and di of the imaginary part may be obtained. Different values of the real part and different values of the imaginary part are combined, so that a total of 16 combinations: (a-ai), (a+bi), (a+ci), (a+di), (b+ai), (b+bi), (b+ci), (b+di), (c+ai), (c+bi), (c+ci), (c+di), (d+ai), (d+bi), (d+ci), and (d+di) can be obtained.

For example, four constellation points corresponding to a constellation point set [1 -1] in Table 1 are (-1+i), (-1-i), (1+i), and (1-i). 16 constellation points corresponding to constellation point locations [-21 -10 10 21] in Table 1 are (-21-21i), (21-10i), (-21+10i), (-21+21i), (-10-211), (-10-10i), (-10+10i), (-10+21i), (10-21i), (10-10i), (10+10i), (10+21i), (21-211), (21-10i), (21+10i), and (21+21i). 64 constellation points corresponding to constellation point locations [-21 -13 -7 -3 3 7 13 21] in Table 1 are (-21-21i), (-21-13i), (-21-7i), (-21-31i), (-10+3i), (-10+7i), (-10+13i), (-10+211), (-13-21i), (-13-13i), (-13-7i), (-13-3i), (-13+3i), (-13+7i), (-13+13i), (-13+21i), (-7-21i), (-7-13i), (-7-7i), (-7-3i), (-7+3i), (-7+7i), (-7+13i), (-7+21i), (-3-21i), (-3-13i), (-3-7i), (-3-3i), (-3+3i), (-3+7i), (-3+13i), (-3+211), (3-3i), (3-13i), (3-7i), (3-3i), (3+3i), (3+7i), (3+13i), (3+211), (7-21i), (7-13i), (7-7i), (7-3i), (7+3i), (7+7i), (7+13i), (7+21i), (13-21i), (13-13i), (13-7i), (13-3i), (13+3i), (13+7i), (13+13i), (13+21i), (21-21i), (21-13i), (21-7i), (21-3i), (21+3i), (21+7i), (21+13i), and (21+21i). By analogy, constellation points corresponding to other constellation point locations in Table 1 are not listed herein.

It should be understood that the correspondence shown in Table 1 may be referred to as an MCS table.

Optionally, in the plurality of modulation schemes, a plurality of constellation points in a constellation point set corresponding to each modulation scheme are symmetric with respect to an origin.

For example, when the constellation points are identified by using sequence numbers, a plurality of sequence numbers identifying the constellation points in each constellation point set may be symmetric with respect to 15.5 or may be symmetric with respect to another value. This is not limited in this application.

The constellation points corresponding to the first modulation scheme described in the foregoing method 500 are determined in a geometric shaping manner. Compared with an MCS table in a current 3GPP technical specification, in the correspondence shown in Table 1, a constellation point set corresponding to each MCS index is added, and the constellation point set corresponding to each MCS index also represents locations to which the bit sequence is mapped in a constellation diagram. Therefore, the column may also be referred to as a mapping (mapping) column.

Table 1 may be considered as an MCS table designed for geometric shaping. However, in an actual communication system, there may alternatively be an MCS table applied to a probabilistic shaping technology. A shaping gain can be achieved when the communication device modulates the bit sequence by using the MCS table determined in the two manners instead of the predefined MCS table. Therefore, when the communication device modulates the bit sequence, how to select an MCS table is an urgent problem to be resolved. The following describes a selection process with reference to FIG. 6.

In a flowchart shown in FIG. 6, the method is shown from a perspective of interaction between communication devices. However, an execution body of the method is not limited in this application. For example, a first device in FIG. 6 may be a terminal device, or may be a chip, a chip system, or a processor that supports the first device in implementing the method, or may be a logical module or software that can implement all or some functions of the first device; and a second device in FIG. 6 may be a network device, or may be a chip, a chip system, or a processor that supports the second device in implementing the method, or may be a logical module or software that can implement all or some functions of the second device.

FIG. 6 is a schematic flowchart of another communication method 600 according to an embodiment of this application. As shown in FIG. 6, the method 600 may include S601 to S603. The following describes in detail steps shown in FIG. 6.

S601: The second device generates indication information.

The indication information may indicate that parameters in a first MCS table or a second MCS table are used for coding and modulation, the first MCS table is designed for geometric shaping or probabilistic shaping, and the second MCS table is predefined.

Because the first MCS table in this application is designed for geometric shaping or probabilistic shaping, when a shaping technology is used, transmission performance achieved by using the first MCS table is better than transmission performance achieved by using the second MCS table.

For example, content indicated by the first indication information is related to whether the shaping technology is used. When the first indication information indicates shaping, it indicates that the parameters in the first MCS table are used for coding and modulation; otherwise, it indicates that the parameters in the second MCS table are used for coding and modulation.

It should be understood that the first information may be carried in physical layer signaling, for example, downlink control information (downlink control information, DCI).

S602: The second device sends the indication information to the first device. Correspondingly, the first device receives the indication information from the second device.

S603: The first device determines, based on the indication information, to modulate a to-be-transmitted information bit sequence by using the first MCS table or the second MCS table.

For descriptions of the information bit sequence, refer to the foregoing related descriptions in the information coding procedure shown in FIG. 2. Details are not described herein again.

For example, if the indication information indicates that the parameters in the first MCS table are used for coding and modulation, the second device determines, based on the indication information, to encode and modulate the to-be-transmitted information bit sequence by using the parameters in the first MCS table. Alternatively, if the indication information indicates that the parameters in the second MCS table are used for coding and modulation, the second device determines, based on the indication information, to encode and modulate the to-be-transmitted information bit sequence by using the parameters in the second MCS table.

Optionally, after S603, the method 600 further includes: The second device encodes and modulates the information bit sequence by using the parameters in the first MCS table or the second MCS table, to obtain a modulated symbol; and sends the modulated symbol to the first device. Correspondingly, the first device receives the modulated symbol, and demodulates and decodes the modulated symbol, to obtain the information bit sequence.

It should be understood that the foregoing demodulation is an inverse process of modulation. A detailed process of modulation and demodulation is not described herein again.

For example, there are different modulation orders in modulation orders corresponding to a same MCS index in the first MCS table and the second MCS table. Alternatively, there are different modulation orders in modulation orders corresponding to a same spectral efficiency in the first MCS table and the second MCS table.

For example, when the modulation orders corresponding to the same index are different, a corresponding modulation order in the first MCS table is higher than a corresponding modulation order in the second MCS table. When the modulation orders corresponding to the same spectral efficiency are different, a corresponding modulation order in the first MCS table is higher than a corresponding modulation order in the second MCS table.

It should be noted that, compared with the second MCS table, in the first MCS table, a lower spectral efficiency corresponds to a higher modulation order.

The following describes a difference and a relationship between the first MCS table and the second MCS table with reference to Table 1 and Table 2.

**Table 2**

| MCS index I_{MCS} | Modulation order Qₘ | Target code rate | Spectral efficiency |
|---|---|---|---|
| 0 | 2 | 120 | 0.2344 |
| 1 | 2 | 157 | 0.3066 |
| 2 | 2 | 193 | 0.3770 |
| 3 | 2 | 251 | 0.4902 |
| 4 | 2 | 308 | 0.6016 |
| 5 | 2 | 379 | 0.7402 |
| 6 | 2 | 449 | 0.8770 |
| 7 | 2 | 526 | 1.0273 |
| 8 | 2 | 602 | 1.1758 |
| 9 | 2 | 679 | 1.3262 |
| 10 | 4 | 340 | 1.3281 |
| 11 | 4 | 378 | 1.4766 |
| 12 | 4 | 434 | 1.6953 |
| 13 | 4 | 490 | 1.9141 |
| 14 | 4 | 553 | 2.1602 |
| 15 | 4 | 616 | 2.4063 |
| 16 | 4 | 658 | 2.5703 |
| 17 | 6 | 438 | 2.5664 |
| 18 | 6 | 466 | 2.7305 |
| 19 | 6 | 517 | 3.0293 |
| 20 | 6 | 567 | 3.3223 |
| 21 | 6 | 616 | 3.6094 |
| 22 | 6 | 666 | 3.9023 |
| 23 | 6 | 719 | 4.2129 |
| 24 | 6 | 772 | 4.5234 |
| 25 | 6 | 822 | 4.8164 |
| 26 | 6 | 873 | 5.1152 |
| 27 | 6 | 910 | 5.3320 |
| 28 | 6 | 948 | 5.5547 |
| 29 | 2 | Reserved | |
| 30 | 4 | Reserved | |
| 31 | 6 | Reserved | |

**Table 3**

| MCS index I_{MCS} | Modulation order Qₘ | Target code rate | Spectral efficiency |
|---|---|---|---|
| 0 | 2 | 120 | 0.2344 |
| 1 | 2 | 157 | 0.3066 |
| 2 | 2 | 193 | 0.3770 |
| 3 | 2 | 251 | 0.4902 |
| 4 | 2 | 308 | 0.6016 |
| 5 | 2 | 379 | 0.7402 |
| 6 | 2 | 449 | 0.8770 |
| 7 | 2 | 526 | 1.0273 |
| 8 | **4** | **301** | **1.1758** |
| 9 | **4** | **339** | **1.3242** |
| 10 | 4 | 340 | 1.3281 |
| 11 | 4 | 378 | 1.4766 |
| 12 | 4 | 434 | 1.6953 |
| 13 | 4 | 490 | 1.9141 |
| 14 | **6** | **369** | **2.1621** |
| 15 | **6** | **411** | **2.4082** |
| 16 | **6** | **439** | **2.5723** |
| 17 | 6 | 438 | 2.5664 |
| 18 | 6 | 466 | 2.7305 |
| 19 | 6 | 517 | 3.0293 |
| 20 | 6 | 567 | 3.3223 |
| 21 | 6 | 616 | 3.6094 |
| 22 | 6 | 666 | 3.9023 |
| 23 | 6 | 719 | 4.2129 |
| 24 | 6 | 772 | 4.5234 |
| 25 | 6 | 822 | 4.8164 |
| 26 | 6 | 873 | 5.1152 |
| 27 | 6 | 910 | 5.3320 |
| 28 | 6 | 948 | 5.5547 |
| 29 | 2 | Reserved | |
| 30 | 4 | Reserved | |
| 31 | 6 | Reserved | |

Table 2 shows the second MCS table, and Table 3 shows the first MCS table. As shown in Table 2 and Table 3, an MCS index included in Table 2 is the same as an MCS index included in Table 3. However, in the second MCS table shown in Table 2, a switching point at which a modulation order is switched from 2 to 4 is an MCS index 10, and a switching point at which a modulation order is switched from 4 to 6 is an MCS index 17. In the first MCS table shown in Table 3, a switching point at which a modulation order is switched from 2 to 4 is an MCS index 8, and a switching point at which a modulation order is switched from 4 to 6 is an MCS index 14. It can be learned that a modulation order switching point in the first MCS table occurs ahead of a modulation order switching point in the second MCS table.

That a modulation order switching point in the first MCS table occurs ahead of a modulation order switching point in the second MCS table may be understood as follows: In the second MCS table shown in Table 2, a switching point at which a modulation order is switched from 2 to 4 is a spectral efficiency 1.3281, and a switching point at which a modulation order is switched from 4 to 6 is a spectral efficiency 2.5664. In the first MCS table shown in Table 3, a switching point at which a modulation order is switched from 2 to 4 is a spectral efficiency **1.1758,** and a switching point at which a modulation order is switched from 4 to 6 is a spectral efficiency **2.1621.** It can be learned that a modulation order switching point in the first MCS table occurs ahead of a modulation order switching point in the second MCS table.

It should be noted that the embodiments of the method 500 and the method 600 may be combined or independently implemented. When the embodiments of the method 500 and the method 600 are combined, the communication method provided in this application may include: The first device indicates, to the second device, that the first modulation scheme in the first MCS table is used for modulating the to-be-transmitted bit sequence. The second device may modulate the to-be-transmitted bit sequence by using the first modulation scheme indicated by the first device. For a detailed procedure of combining the embodiments of the method 500 and the method 600, refer to the foregoing descriptions with reference to the embodiments shown in FIG. 5 and FIG. 6. Details are not described again.

It should be understood that sequence numbers of the foregoing processes do not mean an execution sequence. The execution sequence of the processes should be determined based on functions and internal logic of the processes, and should not be construed as any limitation on implementation processes of embodiments of this application.

FIG. 7 to FIG. 10 are diagrams of possible apparatuses according to embodiments of this application. These apparatuses may be configured to implement functions of the first device or the second device in the foregoing method embodiments, and therefore can also implement beneficial effects of the foregoing method embodiments.

FIG. 7 is a block diagram of a communication apparatus according to an embodiment of this application. As shown in FIG. 7, the communication apparatus (referred to as an apparatus for short below) 700 includes a processing module 710 and a transceiver module 720.

**In a possible design,** the apparatus 700 is configured to implement functions of the first device in the method embodiments shown in FIG. 5 and FIG. 6. For example, the apparatus 700 may correspond to the terminal device in FIG. 1.

**Example 1:** The processing module 710 is configured to: obtain a to-be-transmitted bit sequence; and modulate the bit sequence based on a third modulation scheme, to map the bit sequence to each constellation point in a third constellation point set, to obtain a modulated symbol, where a plurality of constellation points in the third constellation point set are non-uniformly distributed, the third constellation point set is similar to a first constellation point set corresponding to a first modulation scheme, the first constellation point set is a subset of a second constellation point set, the second constellation point set is a set of a plurality of constellation points corresponding to a predefined second modulation scheme, an order of the second modulation scheme is higher than an order of the first modulation scheme, and an order of the third modulation scheme is the same as the order of the first modulation scheme. The transceiver module 720 is configured to send the modulated symbol.

Optionally, the third constellation point set is the same as the first constellation point set.

Optionally, a location of each constellation point in the constellation point set corresponding to the first modulation scheme is determined based on a first mapping relationship, the first mapping relationship indicates a plurality of modulation schemes and a location of a constellation point corresponding to each modulation scheme, and the plurality of modulation schemes include the first modulation scheme.

Optionally, the first mapping relationship includes a correspondence between the plurality of modulation schemes and a plurality of location coordinate sets, each location coordinate set includes a plurality of location coordinates, and each location coordinate identifies a location of one constellation point.

Optionally, each constellation point in the second constellation point set corresponds to one sequence number, each sequence number identifies one constellation point in the second constellation point set, the first mapping relationship includes a correspondence between the plurality of modulation schemes and a plurality of sequence number sets, and each sequence number set includes a plurality of sequence numbers.

Optionally, in the plurality of modulation schemes, a plurality of constellation points in a constellation point set corresponding to each modulation scheme are symmetric with respect to an origin.

Optionally, the second modulation scheme is 1024QAM.

For more detailed descriptions of the processing module 710 and the transceiver module 720, directly refer to related descriptions in the embodiment shown in FIG. 5. Details are not described herein again.

**Example 2:** The transceiver module 720 is configured to receive indication information, where the indication information indicates that parameters in a first MCS table or a second MCS table are used for coding and modulation, the first MCS table is designed for geometric shaping or probabilistic shaping, and the second MCS table is predefined. The processing module 710 is configured to determine, based on the indication information, to encode and modulate a to-be-transmitted information bit sequence by using the first MCS table or the second MCS table.

Optionally, there are different modulation orders in modulation orders corresponding to a same MCS index in the first MCS table and the second MCS table, and when the modulation orders are different, a corresponding modulation order in the first MCS table is higher than a corresponding modulation order in the second MCS table.

Optionally, there are different modulation orders in modulation orders corresponding to a same spectral efficiency in the first MCS table and the second MCS table, and when the modulation orders are different, a corresponding modulation order in the first MCS table is higher than a corresponding modulation order in the second MCS table.

Optionally, the processing module 710 is further configured to modulate and decode the information bit sequence by using the parameters in the first MCS table or the second MCS table, to obtain a modulated symbol. The transceiver module 720 is further configured to send the modulated symbol.

For more detailed descriptions of the transceiver module 720 and the processing module 710, directly refer to related descriptions in the embodiment shown in FIG. 6. Details are not described herein again.

**In another possible design,** the apparatus 700 is configured to implement functions of the second device in the method embodiments shown in FIG. 5 and FIG. 6. For example, the apparatus 700 may correspond to the access network device in FIG. 1.

**Example 1:** The transceiver module 720 is configured to: receive a modulated symbol, where the modulated symbol is obtained by mapping a to-be-transmitted bit sequence to each constellation point in a first constellation point set based on a first modulation scheme, a plurality of constellation points in the third constellation point set are non-uniformly distributed, the third constellation point set is similar to the first constellation point set corresponding to the first modulation scheme, the first constellation point set is a subset of a second constellation point set, the second constellation point set is a set of a plurality of constellation points corresponding to a predefined second modulation scheme, an order of the second modulation scheme is higher than an order of the first modulation scheme, and an order of the third modulation scheme is the same as the order of the first modulation scheme. The processing module 710 is configured to demodulate the modulated symbol, to obtain the bit sequence.

Optionally, the third constellation point set is the same as the first constellation point set.

Optionally, a location of each constellation point in the constellation point set corresponding to the first modulation scheme is determined based on a first mapping relationship, the first mapping relationship indicates a plurality of modulation schemes and a location of a constellation point corresponding to each modulation scheme, and the plurality of modulation schemes include the first modulation scheme.

Optionally, the first mapping relationship includes a correspondence between the plurality of modulation schemes and a plurality of location coordinate sets, each location coordinate set includes a plurality of location coordinates, and each location coordinate identifies a location of one constellation point.

Optionally, each constellation point in the second constellation point set corresponds to one sequence number, each sequence number identifies one constellation point in the second constellation point set, the first mapping relationship includes a correspondence between the plurality of modulation schemes and a plurality of sequence number sets, and each sequence number set includes a plurality of sequence numbers.

Optionally, in the plurality of modulation schemes, a plurality of constellation points in a constellation point set corresponding to each modulation scheme are symmetric with respect to an origin.

Optionally, the second modulation scheme is 1024QAM.

For more detailed descriptions of the transceiver module 720 and the processing module 710, directly refer to related descriptions in the embodiment shown in FIG. 5. Details are not described herein again.

**Example 2:** The processing module 710 is configured to generate indication information, where the indication information indicates that parameters in a first MCS table or a second MCS table are used for coding and modulation, the first MCS table is designed for geometric shaping or probabilistic shaping, and the second MCS table is predefined. The transceiver module 720 is configured to send the indication information.

Optionally, there are different modulation orders in modulation orders corresponding to a same MCS index in the first MCS table and the second MCS table, and when the modulation orders are different, a corresponding modulation order in the first MCS table is higher than a corresponding modulation order in the second MCS table.

Optionally, there are different modulation orders in modulation orders corresponding to a same spectral efficiency in the first MCS table and the second MCS table, and when the modulation orders are different, a corresponding modulation order in the first MCS table is higher than a corresponding modulation order in the second MCS table.

Optionally, the transceiver module 720 is configured to receive a modulated symbol, where the modulated symbol is obtained by encoding and modulating a to-be-transmitted information bit sequence by using the parameters in the first MCS table or the second MCS table. The processing module 710 is configured to demodulate and decode the modulated symbol, to obtain the information bit sequence.

For more detailed descriptions of the processing module 710 and the transceiver module 720, directly refer to related descriptions in the embodiment shown in FIG. 6. Details are not described herein again.

It should be noted that the apparatus 700 may include a sending module but not a receiving module. Alternatively, the apparatus 700 may include a receiving module but not a sending module. Specifically, it may depend on whether the foregoing solution performed by the apparatus 700 includes a sending action and a receiving action.

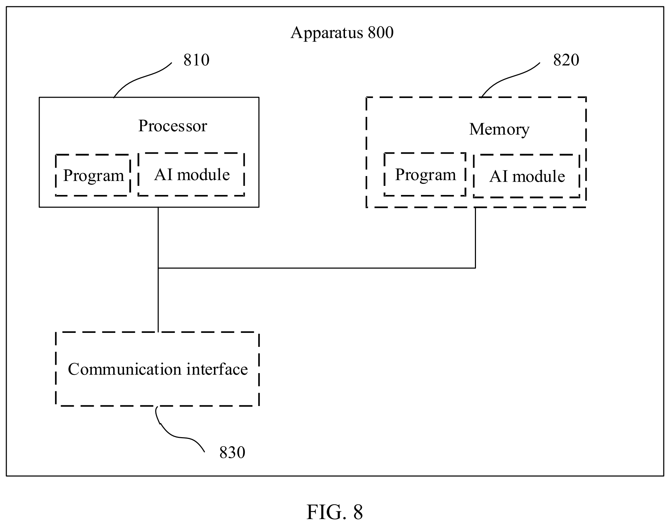

FIG. 8 is another block diagram of a communication apparatus according to an embodiment of this application. As shown in FIG. 8, the communication apparatus (hereinafter referred to as an apparatus for short) 800 includes one or more processors 810. The processor 810 may be a general-purpose processor, a dedicated processor, or the like. For example, the processor 810 may be a baseband processor or a central processing unit. The baseband processor may be configured to process a communication protocol and communication data. The central processing unit may be configured to: control an apparatus (for example, a first device, a second device, or a chip), execute a software program, and process data of the software program.

Optionally, in a design, the processor 810 may include a program (which may also be sometimes referred to as code or instructions), and the program may be run on the processor 810, to enable the apparatus 800 to perform the method performed by the first device or the second device in the foregoing method embodiments. In another possible design, the apparatus 800 includes a circuit (not shown in FIG. 8), and the circuit is configured to implement functions of the first device or the second device in the foregoing method embodiments.

For example, the processor 810 may be configured to execute a computer program or instructions in a memory, to implement steps performed by the first device or the second device in the method embodiment shown in any one of the embodiments shown in FIG. 5 and FIG. 6.

Optionally, the apparatus 800 may include one or more memories 820, and the memory 820 stores a program (which may also be sometimes referred to as code or instructions). The program may be run on the processor 810, to enable the apparatus 800 to perform the method performed by the first device or the second device in the foregoing embodiments.

Optionally, the processor 810 and/or the memory 820 may include an artificial intelligence (artificial intelligence, AI) module, and the AI module is configured to implement an AI-related function. The AI module may be implemented by using software, hardware, or a combination of software and hardware. For example, the AI module may include a radio intelligent controller (radio intelligent controller, RIC) module. For example, the AI module may be a near-real-time RIC or a non-real-time RIC.

Optionally, the processor 810 and/or the memory 820 may further store data. The processor and the memory may be separately disposed, or may be integrated together.

Optionally, the apparatus 800 may further include a communication interface 830. The processor 810 may also be sometimes referred to as a processing unit, and controls an apparatus (for example, the first device or the second device). The communication interface 830 may also be sometimes referred to as a transceiver unit, a transceiver machine, a transceiver circuit, a transceiver, or the like, and is configured to implement a transceiver function of the apparatus.

Optionally, the apparatus 800 further includes a communication interface 830. The processor 810 and the communication interface 830 are coupled to each other. It may be understood that the communication interface 830 may be a transceiver or an input/output interface.

When the apparatus 800 is configured to implement the method shown in FIG. 5 or FIG. 6, the processor 810 is configured to perform a function of the processing module, and the communication interface 830 is configured to perform a function of the sending module or the receiving module. Whether the communication interface 830 is configured to perform sending or receiving may be specifically determined depending on whether a sending action or a receiving action is performed in a solution performed by the apparatus 800.

When the apparatus 800 is a chip used in the first device, the chip implements functions of the first device in the foregoing method embodiments. The chip of the first device receives a signal from another module (for example, a radio frequency module or an antenna) in the first device, where the signal may be sent by the second device to the first device. Alternatively, the chip of the first device sends a signal to another module (for example, a radio frequency module or an antenna) in the first device, where the signal may be sent by the first device to the second device.

When the apparatus 800 is a chip used in the second device, the chip implements functions of the second device in the foregoing method embodiments. The chip of the second device receives a signal from another module (for example, a radio frequency module or an antenna) in the second device, where the signal may be sent by the first device to the second device. Alternatively, the chip of the second device sends a signal to another module (for example, a radio frequency module or an antenna) in the second device, where the signal may be sent by the second device to the first device.

It may be understood that when the apparatus 800 is the first device or the second device, the communication interface 830 may be a transceiver, and may specifically include a transmitter and a receiver. The transmitter is configured to send a signal, and the receiver is configured to receive a signal. When the apparatus 800 is a chip used in the first device or the second device, the communication interface 830 may be an input/output circuit. The input circuit may be configured to perform receiving, and the output interface may be configured to perform sending.

It should be noted that, the foregoing method embodiments may be applied to a processor, or implemented by a processor. The processor may be an integrated circuit chip and has a signal processing capability. In an implementation process, steps in the foregoing method embodiments can be implemented by using a hardware integrated logic circuit in the processor, or by using instructions in a form of software.

The processor may be a general-purpose processor, a digital signal processor (digital signal processor, DSP), an application-specific integrated circuit (application-specific integrated circuit, ASIC), a field programmable gate array (field programmable gate array, FPGA) or another programmable logic device, a discrete gate or transistor logic device, a discrete hardware component, or any combination thereof. The general-purpose processor may be a microprocessor, or may be any conventional processor, or the like.

The steps in the methods disclosed with reference to embodiments of this application may be directly performed and completed by a hardware decoding processor, or may be performed and completed by using a combination of hardware in the decoding processor and a software module. The software module may be located in a mature storage medium in the field, for example, a random access memory, a flash memory, a read-only memory, a programmable read-only memory, an electrically erasable programmable memory, or a register. The storage medium is located in the memory, and the processor reads information in the memory and completes the steps in the foregoing methods in combination with hardware of the processor.

This application further provides a computer-readable medium. The computer-readable medium stores a computer program. When the computer program is executed by a computer, functions of the foregoing method embodiments are implemented.

This application further provides a computer program product including instructions. When the computer program product is executed by a computer, functions of the foregoing method embodiments are implemented.

The memory in embodiments of this application may be a volatile memory or a non-volatile memory, or may include both a volatile memory and a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. Through example but not limitative description, many forms of RAMs may be used, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchronous link dynamic random access memory (synchlink DRAM, SLDRAM), and a direct rambus dynamic random access memory (direct rambus RAM, DR RAM). It should be noted that the memory of the systems and methods described in this specification includes but is not limited to these and any memory of another proper type.

All or a part of the methods provided in the foregoing embodiments may be implemented by software, hardware, firmware, or any combination thereof. When software is used to implement the embodiments, all or a part of the embodiments may be implemented in a form of a computer program product. The computer program product may include one or more computer instructions. When the computer program instructions are loaded and executed on a computer, all or a part of the procedures or functions in embodiments of this application are generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber (DSL)) or wireless (for example, infrared, radio, or microwave) manner. The computer-readable storage medium may be any usable medium accessible by the computer, or a data storage device, for example, a server or a data center, integrating one or more usable media. The usable medium may be a magnetic medium (for example, a floppy disk, a hard disk drive, or a magnetic disk), an optical medium (for example, a DVD), a semiconductor medium (for example, a solid state disk solid state disk (SSD)), or the like.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and module, refer to a corresponding process in the foregoing method embodiments. Details are not described herein again.

In the several embodiments provided in this application, it should be understood that the disclosed system, apparatus, and method may be implemented in other manners. For example, the described apparatus embodiments are merely examples. For example, division into the units is merely logical function division and may be other division during actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, or each of the units may exist alone physically, or two or more units may be integrated into one unit.

When the functions are implemented in a form of a software functional unit and sold or used as an independent product, the functions may be stored in a computer-readable storage medium. Based on such an understanding, the technical solutions of this application essentially, or the part contributing to some embodiments, or some of the technical solutions may be implemented in a form of a software product. The computer software product is stored in a storage medium, and includes several instructions for instructing a computer device (which may be a personal computer, a server, or a network device) to perform all or some of the steps of the methods described in embodiments of this application. The foregoing storage medium includes any medium that can store program code, such as a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A communication method, comprising:
obtaining a to-be-transmitted bit sequence;
modulating the bit sequence based on a third modulation scheme, to map the bit sequence to each constellation point in a third constellation point set, to obtain a modulated symbol, wherein a plurality of constellation points in the third constellation point set are non-uniformly distributed, the third constellation point set is similar to a first constellation point set corresponding to a first modulation scheme, the first constellation point set is a subset of a second constellation point set, the second constellation point set is a set of a plurality of constellation points corresponding to a predefined second modulation scheme, an order of the second modulation scheme is higher than an order of the first modulation scheme, and an order of the third modulation scheme is the same as the order of the first modulation scheme; and
sending the modulated symbol.

2. The method according to claim 1, wherein the third constellation point set is the same as the first constellation point set.

3. The method according to claim 1 or 2, wherein a location of each constellation point in the constellation point set corresponding to the first modulation scheme is determined based on a first mapping relationship, the first mapping relationship indicates a plurality of modulation schemes and a location of a constellation point corresponding to each modulation scheme, and the plurality of modulation schemes comprise the first modulation scheme.

4. The method according to claim 3, wherein the first mapping relationship comprises a correspondence between the plurality of modulation schemes and a plurality of location coordinate sets, each location coordinate set comprises a plurality of location coordinates, and each location coordinate identifies a location of one constellation point.

5. The method according to claim 3, wherein each constellation point in the second constellation point set corresponds to one sequence number, each sequence number identifies one constellation point in the second constellation point set, the first mapping relationship comprises a correspondence between the plurality of modulation schemes and a plurality of sequence number sets, and each sequence number set comprises a plurality of sequence numbers.

6. The method according to any one of claims 3 to 5, wherein in the plurality of modulation schemes, a plurality of constellation points in a constellation point set corresponding to each modulation scheme are symmetric with respect to an origin.

7. The method according to any one of claims 1 to 6, wherein the third modulation scheme is 1024 quadrature amplitude modulation QAM.

8. A communication method, comprising:
receiving a modulated symbol, wherein the modulated symbol is obtained by mapping a bit sequence to each constellation point in a third constellation point set based on a third modulation scheme, a plurality of constellation points in the third constellation point set are non-uniformly distributed, the third constellation point set is similar to a first constellation point set corresponding to a first modulation scheme, the first constellation point set is a subset of a second constellation point set, the second constellation point set is a set of a plurality of constellation points corresponding to a predefined second modulation scheme, an order of the second modulation scheme is higher than an order of the first modulation scheme, and an order of the third modulation scheme is the same as the order of the first modulation scheme; and
demodulating the modulated symbol, to obtain the bit sequence.

9. The method according to claim 8, wherein the third constellation point set is the same as the first constellation point set.

10. The method according to claim 8 or 9, wherein a location of each constellation point in the constellation point set corresponding to the first modulation scheme is determined based on a first mapping relationship, the first mapping relationship indicates a plurality of modulation schemes and a location of a constellation point corresponding to each modulation scheme, and the plurality of modulation schemes comprise the first modulation scheme.

11. The method according to claim 10, wherein the first mapping relationship comprises a correspondence between the plurality of modulation schemes and a plurality of location coordinate sets, each location coordinate set comprises a plurality of location coordinates, and each location coordinate identifies a location of one constellation point in the constellation diagram.

12. The method according to claim 10, wherein each constellation point in the second constellation point set corresponds to one sequence number, each sequence number identifies one constellation point in the second constellation point set, the first mapping relationship comprises a correspondence between the plurality of modulation schemes and a plurality of sequence number sets, and each sequence number set comprises a plurality of sequence numbers.

13. The method according to any one of claims 10 to 12, wherein in the plurality of modulation schemes, a plurality of constellation points in a constellation point set corresponding to each modulation scheme are symmetric with respect to an origin.

14. The method according to any one of claims 9 to 13, wherein the second modulation scheme is 1024 quadrature amplitude modulation QAM.

15. A communication method, comprising:
receiving indication information, wherein the indication information indicates that parameters in a first modulation and coding scheme MCS table or a second MCS table are used for coding and modulation, the first MCS table is designed for geometric shaping or probabilistic shaping, and the second MSC table is predefined; and
determining, based on the indication information, to encode and modulate a to-be-transmitted information bit sequence by using the first MCS table or the second MCS table.

16. The method according to claim 15, wherein content indicated by the indication information is related to whether a shaping technology is used.

17. The method according to claim 15 or 16, wherein there are different modulation orders in modulation orders corresponding to a same MCS index in the first MCS table and the second MCS table, and when the modulation orders are different, a corresponding modulation order in the first MCS table is higher than a corresponding modulation order in the second MCS table.

18. The method according to claim 15 or 16, wherein there are different modulation orders in modulation orders corresponding to a same spectral efficiency in the first MCS table and the second MCS table, and when the modulation orders are different, a corresponding modulation order in the first MCS table is higher than a corresponding modulation order in the second MCS table.

19. The method according to any one of claims 15 to 18, wherein the method further comprises:
modulating the bit sequence by using the parameters in the first MCS table or the second MCS table, to obtain a modulated symbol; and
sending the modulated symbol.

20. A communication method, comprising:
generating indication information, wherein the indication information indicates that parameters in a first modulation and coding scheme MCS table or a second MCS table are used for modulation, the first MCS table is determined in a geometric shaping manner or a probabilistic shaping manner, and the second MSC table is predefined; and
sending the indication information.

21. The method according to claim 20, wherein content indicated by the indication information is related to whether a shaping technology is used.

22. The method according to claim 20 or 21, wherein there are different modulation orders in modulation orders corresponding to a same MCS index in the first MCS table and the second MCS table, and when the modulation orders are different, a corresponding modulation order in the first MCS table is higher than a corresponding modulation order in the second MCS table.

23. The method according to claim 20 or 21, wherein there are different modulation orders in modulation orders corresponding to a same spectral efficiency in the first MCS table and the second MCS table, and when the modulation orders are different, a corresponding modulation order in the first MCS table is higher than a corresponding modulation order in the second MCS table.

24. The method according to any one of claims 20 to 23, wherein the method further comprises:
receiving a modulated symbol, wherein the modulated symbol is obtained by encoding and modulating a to-be-transmitted information bit sequence by using the parameters in the first MCS table or the second MCS table; and
demodulating and decoding the modulated symbol, to obtain the information bit sequence.

25. A communication apparatus, comprising a module configured to implement the method according to any one of claims 1 to 24.

26. A communication apparatus, comprising a processor configured to enable, by executing a computer program and/or through a logic circuit, the communication apparatus to implement the method according to any one of claims 1 to 24.

27. The apparatus according to claim 26, further comprising a memory configured to store the computer program and/or a configuration file of the logic circuit.

28. The apparatus according to claim 26 or 27, further comprising a communication interface configured to input and/or output a signal.

29. A computer-readable storage medium, wherein the computer-readable storage medium stores a computer program, and when the computer program is executed by a processor, the method according to any one of claims 1 to 24 is performed.

30. A communication system, comprising a first device and a second device, wherein the first device is configured to implement the method according to any one of claims 1 to 7, and the second device is configured to implement the method according to any one of claims 8 to 14; or the first device is configured to implement the method according to any one of claims 15 to 19, and the second device is configured to implement the method according to any one of claims 20 to 24.
